# EUROPÄISCHE PATENTSCHRIFT

(11) **EP 0 316 523 B1**
(45) Veröffentlichungstag und Bekanntmachung des Hinweises auf die Patenterteilung: **12.01.1994**
(21) Anmeldenummer: 88113758.2
(22) Anmeldetag: 24.08.1988
(51) Int. Cl.: H01J 37/34, C23C 14/34

(54) **Zerstäubungskatode nach dem Magnetronprinzip**
Control for sputtering according to the magnetron principle
Cathode pour pulvérisation selon le principe magnétron

(30) Priorität: 16.11.1987 DE 3738845
(43) Veröffentlichungstag der Anmeldung: 24.05.1989
(73) Patentinhaber: LEYBOLD AKTIENGESELLSCHAFT, D-63450 Hanau (DE)
(72) Erfinder: Wirz, Peter, Dr. Dipl.-Phys., D-6464 Linsengericht 5 (DE); Bräuer, Günter, Dr. Dipl.-Phys., S-6296 Waldernbach (DE)

(56) Entgegenhaltungen:
- EP-A- 0 095 211
- US-A- 4 517 070
- PATENT ABSTRACTS OF JAPAN vol. 7, no. 195 (C-183)(1340) 25 August 1983, & JP-A-58 96875

## Beschreibung

Die Erfindung betrifft eine Zerstäubungskatode nach dem Magnetronprinzip mit einem Katodengrundkörper, mit einem eine Zerstäubungsfläche und Umfangsflächen aufweisenden Target und einem hinter dem Target angeordneten Magnetsystem mit ineinanderliegenden, auf dem Umfang in sich geschlosseen Polen entgegengesetzter Polarität zur Erzeugung von magnetischen Feldlinien, die aus dem Target austreten und nach dem Durchlaufen von bogenförmigen Bahnen wieder in das Target eintreten und so über der Zerstäubungsfläche einen in sich geschlossenen magnetischen Tunnel bilden, der das im Betrieb auftretende Plasma einschließt und dadurch einerseits eine in der Zerstäubungsfläche liegende Erosionszone und andererseits außerhalb der Erosionzone liegende nicht erodierbare Randbereiche abgrenzt, wobei der Katodengrundkörper und die Umfangsflächen des Targets von einer Dunkelraumabschirmung umgeben sind.

Eine derartige Zerstäubungskatode ist in dem Aufsatz "The planar magnetron", von John S. Chapin, beschrieben, veröffentlicht in Research/Development, Januar 1974, Seiten 39-41. Die Unterteilung in eine Erosionszone, die ein getreues Abbild des im Betrieb auftretenden Plasmas ist, einerseits, und in innerhalb und außerhalb der Erosionszone liegende nicht erodierbare Bereiche andererseits geschieht durch den magnetischen Tunnel zwangsläufig. Solange elektrisch leitfähige, insbesondere metallische Targets in nicht-reaktiver Atmosphäre zerstäubt werden, spielt diese Unterteilung keine entscheidende Rolle. Sobald jedoch leitfähige, insbesondere metallische Targets in reaktiver Atmosphäre zerstäubt werden, schlagen sich in den nicht-erodierbaren Bereichen Reaktionsprodukte des Targetmaterials nieder, die elektrische Nichtleiter sind und beispielsweise aus den Oxiden, Nitriden und Karbiden des zerstäubten Metalls bestehen.Während die Abscheidurgvon Reaktionsprodukten im Bereich der Erosionszone durch die dort sehr hohe Zerstäubungsrate verhindert wird, kondensieren die Reaktionsprodukte in der Nähe der Erosionszone. Dieser Vorgang wird auch als "Rücksputter-Effekt" bezeichnet.

Dieser Rücksputter-Effekt ist besonders ausgeprägt an den Ecken der Zerstäubungsfläche und an Bereichen, an denen unterhalb der Katode die Magnete angeordnet sind. Aus den Magneten treten nämlich die Magnetfeldlinien senkrecht aus und durchdringen somit auch die Oberfläche des Targets in senkrechter Richtung. Das magnetische Feld verläuft an diesen Stellen parallel zum elektrischen Feld, so daß an diesen Stellen keine Bedingungen für das sogenannte Magnetronsputtern erfüllt sind und eine Rückbeschichtung von Material an diesen Stellen der Oberfläche auftritt.

Nicht-leitende Stellen auf der Zerstäubungsfläche ermöglichen jedoch eine elektrische Aufladung. Zwischen nicht-leitfähigen und leitfähigen Bereichen findet deshalb ein Ladungsausgleich in Form einer Funkenentladung statt. Diese Funkenentladung bleibt aber in der Regel nicht auf die Zerstäubungsfläche beschränkt, da die Potentialdifferenz gegen Masse weitaus größer ist. Wird aber ein Überschlag zwischen Katode und Masse erzeugt, so führt dieser Kurzschluß zu einer Unterbrechung des Sputterprozesses durch Abschalten der Stromversorgung. Während dieser Zeitspanne ist ein Überschuß von Reaktionsgas in der Katodenumgebung vorhanden, da ein entsprechender Verbrauch fehlt. Dieses Überangebot von Reaktionsgas führt zu einer zusätzlichen Belegung der Zerstäubungsfläche mit nicht-leitfähigem Material, welches der Katode zusätzlich instabile Betriebseigenschaften verleiht. Eine einmal aufgetretene Funkenentladung hat somit weitere Funkenentladungen zur Folge, so daß nach einer gewissen Zeit der Sputterprozeß abgebrochen werden muß.

Dieser Effekt liesse sich zwar durch einen Ersatz der üblichen Gleichspannungs-Stromversorgung durch eine Hochfrequenz-Stromversorgung weitgehend unterdrücken, jedoch wird dadurch eine Katodenzerstäubungsanlage beträchtlich teurer in der Anschaffung und in der Unterhaltung. Man trachtet also stets danach, Gleichspannungs-Stromversorgungen einzusetzen.

Der Erfindung liegt daher die Aufgabe zugrunde, eine Zerstäubungskatode der eingangs beschriebenen Gattung anzugeben, die auch für reaktive Zerstäubungsprozesse eingesetzt werden kann und die auch bei Versorgung mit Gleichspannung über lange Zeit ein stabiles Betriebsverhalten aufweist und zu homogenen bzw. gleichförmigen Schichten auf den Endprodukten führt.

Die Lösung der gestellten Aufgabe erfolgt bei der eingangs angegebenen Zerstäubungskatode erfindungsgemäß dadurch, daß die außerhalb der Erosionszone liegenden Randbereiche des Targets von einem parallel zur Zerstäubungsfläche verlaufenden, einen Innenrand aufweisenden flanschförmigen Fortsatz der Dunkelraumabschirmung überdeckt sind, und daß sich zwischen der Dunkelraumabschirmung und dem Fortsatz einerseits und den abgegrenzten Randbereichen der Zerstäubungsfläche, den Umfangsflächen des Targets und dem Katodengrundkörper andererseits mindestens eine auf ein Zwischenpotential einstellbare, vom Target und von der Dunkelraumabschirmung isolierte, einen Innenrand aufweisende Elektrode befindet, die der Dunkelraumabschirmung geometrisch ähnlich ist.

Diese sogenannte "Zwischenelektrode" kann auf einem fest einstellbaren Zwischenpotential angeordnet werden, es ist aber mit besonderem Vorteil möglich, diese Elektrode einfach isoliert anzubringen, so daß sie sich frei auf ein Zwischenpotential einstellen kann ("floatend").

Die erfindungsgemäße Bauweise bringt folgende Vorteile mit sich: Da sich Massepotential in Form des flanschförmigen Fortsatzes der Dunkelraumabschirmung in unmittelbarer Nähe der Plasmaentladung befindet, werden Elektronen über das Massepotential abgesaugt, und in unmittelbarer Umgebung der Kante der Dunkelraumabschirmung wird die Energiedichte des Plasmas verringert. Ohne die erfindungsgemäße Zwischenelektrode hätte dies zur Folge, daß zwischen der Kante der Dunkelraumabschirmung und dem Plasma ein schmaler Bereich gebildet wird, in dem eine Rückbeschichtung des Targets eintritt, wodurch wiederum die gefürchteten Funkenentladungen auftreten. Durch das Vorhandensein der Zwischenelektrode, deren zum Target parallel verlaufender Teil dem flanschförmigen Fortsatz der Dunkelraumabschirmung vorzugsweise geometrisch ähnlich ist, sowie durch die Einstellung eines Zwischenpotentials an dieser Elektrode wird eine Verringerung der Energiedichte des Plasmas vermieden und eine Rückbeschichtung der Zerstäubungsfläche wirksam verhindert.

Durch die angegebene Zwischenelektrode wird gewissermaßen ein Potentialgradient zwischen Katode und Masse erzeugt, wodurch wiederum über einen vielfach längeren Zeitraum ein stabiles Betriebsverhalten der Zerstäubungskatode erreicht wird.

Es ist dabei besonders vorteilhaft, wenn der umlaufende Innenrand der auf ein Zwischenpotential einstellbaren Elektrode in Richtung auf die Mitte "M" der Zerstäubungsfläche um ein Maß "s" weiter vorgezogen ist, als der geometrisch ähnliche umlaufende Innenrand des flanschförmigen Fortsatzes der Dunkelraumabschirmung. Das Maß "s" wird dabei vorteilhaft zwischen 2 und 5 mm, vorzugsweise zwischen 3 und 4 mm, gewählt.

Das gleiche Problem tritt nunmehr auch in der Mitte der Zerstäubungsfläche auf, da auch hier keine Erosionszone vorhanden ist, weil beispielsweise die Magnetfeldlinien senkrecht aus der Katodenoberfläche austreten. Um auch hier eine Rückbeschichtung und die damit verbundenen Funkenüberschläge zu vermeiden, wird gemäß der weiteren Erfindung über der Mitte "M" der Zerstäubungsfläche und über dem durch den magnetischen Tunnel und die Erosionszone abgegrenzten Bereich eine weitere, diesen Bereich zumindest weitgehend abdeckende Elektrode angeordnet, die sich gleichfalls auf einem einstellbaren Potential befindet. Der Erfindungsgegenstand hat sich außerordentlich gut für das reaktive Aufstäuben von Isolierstoffschichten bewährt. So konnte beispielsweise für die Herstellung von Aluminiumnitrid durch Sputtern mit Gleichspannung über mehr als 8 Stunden eine stabile Prozeßführung erreicht werden.

Weitere vorteilhafte Ausgestaltungen des Erfindungsgegenstandes ergeben sich aus den übrigen Unteransprüchen.

Drei Ausführungsbeispiele des Erfindungsgegenstandes werden nachfolgend anhand der Figuren 1 bis 3 näher erläutert.

Es zeigen:
- Figur 1: eine perspektivische Darstellung einer in der Mitte geschnittenen Rechteckkatode mit quaderförmiger Hüllfläche für die Dunkelraumabschirmung,
- Figur 2: eine perspektivische Darstellung analog Figur 1, jedoch mit durch Kreisring- bzw. Zylinderabschnitte begrenzten Oberflächenteilen am Ende der Katode und
- Figur 3: einen Axialschnitt durch eine in eine Wand der Vakuumkammer eingebaute rotationssymmetrische Zerstäubungskatode.

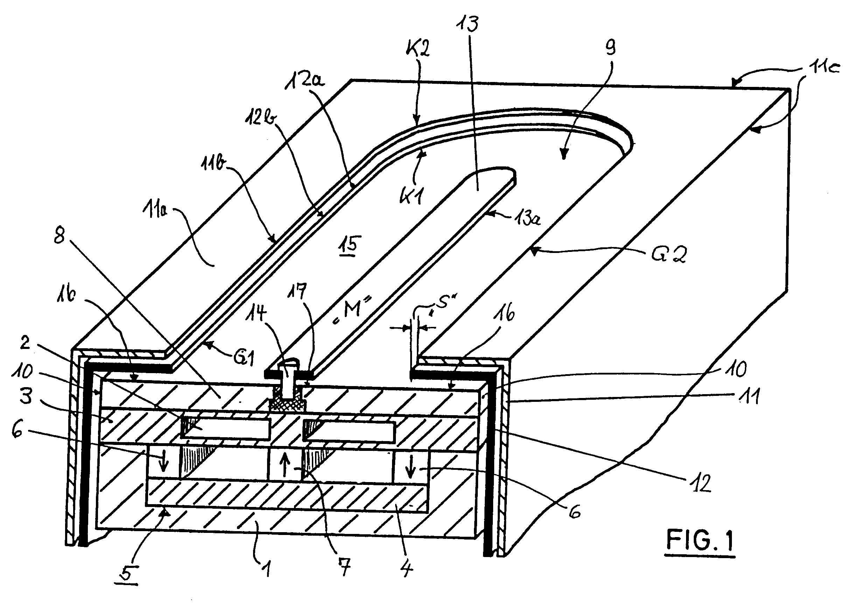

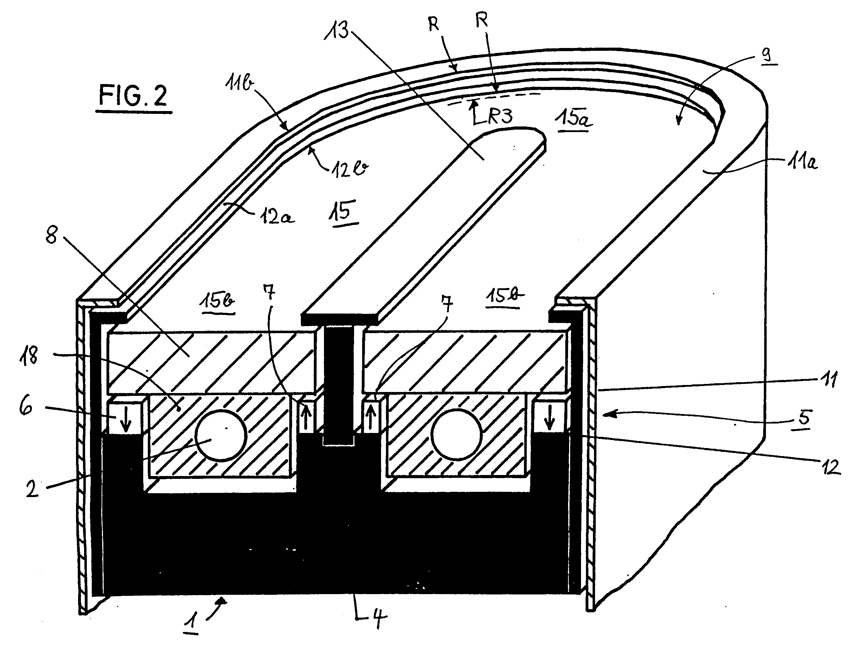

Die Zerstäubungskatoden nach den Figuren 1 und 2 befinden sich im Innern einer Vakuumkammer und ruhen auf bzw. hängen an Isolierstoffstützen mit entsprechenden Spannungsdurchführungen.

In Figur 1 ist ein Katodengrundkörper 1 dargestellt, der wannenförmig ausgebildet und durch eine mit einem Kühlkanal 2 versehene, kongruente Targethalteplatte 3 verschlossen ist. Die Teile 1 und 3 bestehen aus einem amagnetischen Werkstoff, vorzugsweise aus Kupfer. In dem dadurch gebildeten Hohlraum befindet sich ein Magnetsystem 5, das aus einer ferromagnetischen Jochplatte 4 und zahlreichen Permanentmagneten 6 und 7 besteht, deren Magnetisierungsrichtung durch die eingezeichneten Pfeile angedeutet ist. Die äußeren Permanentmagnete 6 bilden eine in sich geschlossene Reihe mit der Umrißlinie einer Rennbahn, während die inneren Permanentmagnete 7 eine lineare Reihe bilden, die parallel zu den Langseiten der Rennbahn verläuft. Auf der Targethalteplatte 3 ist ein Target 8 befestigt, beispielsweise durch Bonden. Dieses Target hat die Form eines flachen Quaders, dessen größte freie Oberfläche die sogenannte Zerstäubungsfläche 9 bildet. Das Target 8 besitzt weiterhin Umfangsflächen 10.

Durch das Magnetsystem 5 werden magnetische Feldlinien erzeugt, die aus dem Target 8 austreten und nach dem Durchlaufen von bogenförmigen Bahnen wieder in dieses eintreten. Dadurch wird über der Zerstäubungsfläche 9 ein in sich geschlossener magnetischer Tunnel gebildet, dessen in der Zerstäubungsfläche 9 liegende Grundfläche gleichfalls die Form einer Rennbahn hat. Dieser magnetische Tunnel schließt das in Betrieb auftretende Plasma ein, durch dessen Zerstäubungswirkung innerhalb der Zerstäubungsfläche 9 eine sogenannte Erosionszone gebildet wird.

Katodengrundkörper 1, Targethalteplatte 3 und die Umfangsflächen 10 des Targets 8 sind von einer auf Massepotential liegenden metallischen Dunkelraumabschirmung 11 umgeben, die einen parallel zur Zerstäubungsfläche 9 verlaufenden flanschförmigen Fortsatz 11a besitzt, der einen Innenrand 11b aufweist. Zwischen der Dunkelraumabschirmung 11 mit dem Fortsatz 11a einerseits und den abgegrenzten Randbereichen der Zerstäubungsfläche 9, den Umfangsflächen 10 des Targets 8 und dem Katodengrundkörper 1 andererseits ist eine auf ein Zwischenpotential einstellbare, vom Target 8 und von der Dunkelraumabschirmung 11 isolierte, einen Innenrand 12a aufweisende Elektrode 12 angeordnet, die der Dunkelraumabschirmung geometrisch ähnlich ist, d.h. gleichfalls einen nach innen ragenden flanschförmigen Fortsatz 12a besitzt. Die isolierte Elektrode 12 kann sich auf ein durch die Betriebsbedingungen bedingtes Zwischenpotential frei einstellen. Der umlaufende Innenrand 12b der Elektrode 12 ist in Richtung auf die Mitte "M" der Zerstäubungsfläche 9 um ein Maß "s" weiter vorgezogen, als der geometrisch ähnlich verlaufende Innenrand 11b des flanschförmigen Fortsatzes 11a der Dunkelraumabschirmung 11.

Über der Mitte "M" der Zerstäubungsfläche 9 befindet sich eine weitere Elektrode 13, die sich gleichfalls frei floatend auf ein Zwischenpotential zwischen der Katodenspannung und Massepotential einstellen kann. Die Mittelelektrode 13 ist durch Isolierstützen 14 auf der Targethalteplatte 3 befestigt und weist natürlich gegenüber der Zerstäubungsfläche 9 einen Abstand auf. Sämtliche Abstände der frei floatenden Elektroden 12 und 13 gegenüber dem Target und dem Katodengrundkörper einerseits und der Dunkelraumabschirmung 11 andererseits sind kleiner gewählt, als dies dem bei Betriebsbedingungen auftretenden Dunkelraumabstand entspricht.

Die Grundfläche des über der Zerstäubungsfläche 9 gebildeten magnetischen Tunnels entspricht in etwa dem rennbahnförmigen Zwischenraum zwischen dem Innenrand 12b und dem Außenrand 13a der Elektrode 13. Dieser Bereich ist es auch, der während des Betriebes der Katode zerstäubt bzw. erodiert wird. Die außerhalb der Erosionszone 15 liegenden Randbereiche 16 des Targets 8, die nicht der Zerstäubung unterliegen, werden von dem flanschförmigen Fortsatz 11a der Dunkelraumabschirmung 11 überdeckt und hier auch hinsichtlich ihrer Flächenausdehnung definiert.

Unterhalb der Elektrode 13 befindet sich ein analoger Mittenbereich 17.

Die Zerstäubungskatode nach Figur 2 ist in analoger Weise aufgebaut, so daß sich Wiederholungen erübrigen und gleiche Bezugszeichen verwendet werden können. In diesem Fall befindet sich jedoch außer der Zwischenelektrode 12 auch der Katodengrundkörper 1, der mit dem Magnetjoch gleichzusetzen ist, auf floatendem Potential, desgleichen die Elektrode 13. Um auch hier die Kühlung des Targets 8 zu bewirken, ist das Target 8 auf seiner Rückseite mit einem Kühlkörper 18 versehen, mit dem das Target durch Bonden verbunden ist und der gegenüber dem floatenden Katodengrundkörper 1 isoliert angeordnet ist. Die isolierenden Zwischenlagen sind der Einfachheit halber nicht dargestellt.

Bei der Zerstäubungskatode nach Figur 2 liegt gleichfalls eine langgestreckte Zerstäubungsfläche 9 vor, und das Magnetsystem 5 dient zur Erzeugung einer gleichfalls rennbahnförmigen Erosionszone 15 mit zwei kreisringförmigen Endbereichen 15a, von denen nur der hintere dargestellt ist. Diese Endbereiche 15a sind durch zwei lineare Mittenbereiche 15b miteinander verbunden. Die umlaufenden Innenränder 11b und 12b der auf ein Zwischenpotential einstellbaren Elektrode 12 und des Fortsatzes 11a der Dunkelraumabschirmung 11 sind im Bereich der kreisringförmigen Endbereiche 15a durch je einen Halbkreis begrenzt, deren Halbmesser R1 und R2 dem äußeren Halbmesser R3 der Endbereiche 15a der Erosionszone 15 entsprechen.

Bei einem Target 8 mit einer rechteckigen Zerstäubungsfläche 9 nach Figur 1 ist der Fortsatz 11a der Dunkelraumabschirmung 11 an seinem Außenrand 11c von einem geometrisch ähnlichen Rechteck und an seinem Innenrand 11b von zwei Halbkreisen K2 und zwei diese Halbkreise miteinander verbindenden, zu den Langseiten des Rechtecks parallel verlaufenden Geraden G2 begrenzt.

In analoger Weise ist bei einem Target 8 mit einer rechteckigen Zerstäubungsfläche, gleichfalls nach Figur 1, die auf ein Zwischenpotential einstellbare Elektrode 12 gleichfalls an ihrem Außenrand von einem geometrisch ähnlichen Rechteck und an ihrem Innenrand 12b von zwei Halbkreisen K1 und zwei diese Halbkreise miteinander verbindenden, zu den Langseiten des Rechtecks parallel verlaufenden Geraden G1 begrenzt.

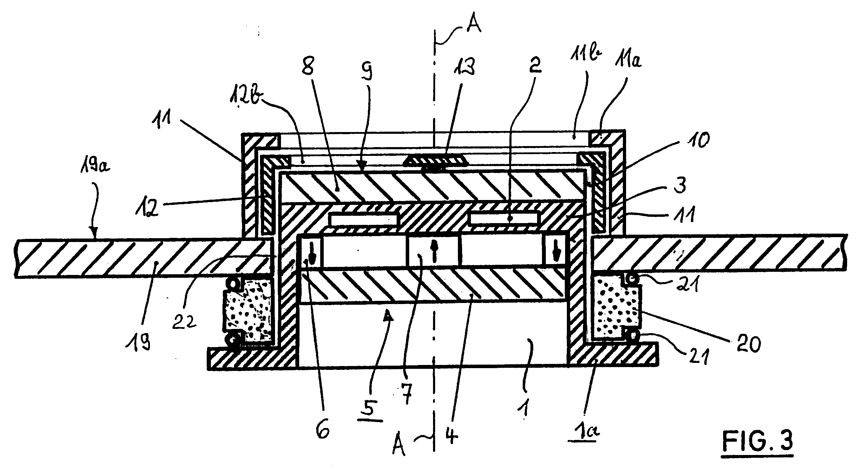

Figur 3 zeigt eine Zerstäubungskatode in Analogie zu Figur 1, jedoch mit den Unterschieden, daß die Katode rotationssymmetrisch zu ihrer Achse A-A ausgebildet ist und daß sie ferner in die Wand 19 einer Vakuumkammer eingesetzt ist, wobei die dem Vakuum zugekehrte Seite mit 19a beziffert ist. Soweit Teile mit gleicher oder analoger Funktion verwendet werden, werden auch die gleichen Bezugszeichen verwendet.

Der Katodengrundkörper 1 ist unter Belassung eines Ringspaltes 22 in die Wand 19 eingesetzt. Zwischen der Wand 19 und dem Flansch 1a befinden sich ein ringförmiger Isolator 20 und zwei Dichtungsringe 21 und 22. Der jenseits der Wandfläche 19a liegende Teil des Katodengrundkörpers 1, die Targethalteplatte 3 und die Umfangsfläche 10 des Targets 8 sind in analoger Weise wie in den Figuren 1 und 2 von der Dunkelraumabschirmung 11 und der auf einem Zwischenpotential befindlichen Elektrode 12 umgeben.

Zwischen den Rechteck- oder Langkatoden nach den Figuren 1 und 2 und der Topfkatode nach Figur 3 bestehen keine prinzipiellen Unterschiede. Man kann sich die Langkatode nach Figur 2 auch beispielsweise dadurch entstanden denken, daß man eine Topfkatode nach Figur 3 entlang einer diametralen Ebene durchtrennt, die beiden Segmente auseinanderrückt und den Zwischenraum mit einem rechteckigen Katodenteil ausfüllt, das im Querschnitt dem Axialschnitt durch die Topfkatode entspricht.

## Patentansprüche

1. Zerstäubungskatode nach dem Magnetronprinzip mit einem Katodengrundkörper, mit einem eine Zerstäubungsfläche und Umfangsflächen aufweisenden Target und einem hinter dem Target angeordneten Magnetsystem mit ineinanderliegenden, auf dem Umfang in sich geschlossenen Polen entgegengesetzter Polarität zur Erzeugung von magnetischen Feldlinien, die aus dem Target austreten und nach dem Durchlaufen von bogenförmigen Bahnen wieder in das Target eintreten und so über der Zerstäubungsfläche einen in sich geschlossenen magnetischen Tunnel bilden, der das im Betrieb auftretende Plasma einschließt und dadurch einerseits eine in der Zerstäubungsfläche liegende Erosionszone und andererseits außerhalb der Erosionszone liegende nicht erodierbare Randbereiche abgrenzt, wobei der Katodengrundkörper und die Umfangsflächen des Targets von einer Dunkelraumabschirmung umgeben sind, dadurch gekennzeichnet, daß die außerhalb der Erosionszone (15) liegenden Randbereiche (16) des Targets (8) von einem parallel zur Zerstäubungsfläche (9) verlaufenden, einen Innenrand (11b) aufweisenden flanschförmigen Fortsatz (11a) der Dunkelraumabschirmung (11) überdeckt sind, und daß sich zwischen der Dunkelraumabschirmung mit dem Fortsatz (16a) einerseits und den abgegrenzten Randbereichen (16) der Zerstäubungsfläche (9), den Umfangsflächen (10) des Targets (8) und dem Katodengrundkörper (1) andererseits mindestens eine auf ein Zwischenpotential einstellbare, vom Target und von der Dunkelraumabschirmung isolierte, einen Innenrand (12b) aufweisende Elektrode (12) befindet, die der Dunkelraumabschirmung (11) geometrisch ähnlich ist.

2. Zerstäubungskatode nach Anspruch 1, dadurch gekennzeichnet, daß die isolierte Elektrode (12) sich auf ein Zwischenpotential frei einstellbar angeordnet ist.

3. Zerstäubungskatode nach Anspruch 1, dadurch gekennzeichnet, daß der umlaufende Innenrand (12b) der auf ein Zwischenpotential einstellbaren Elektrode (12) in Richtung auf die Mitte "M" der Zerstäubungsfläche (9) um ein Maß "s" weiter vorgezogen ist als der geometrisch ähnliche umlaufende Innerand (11b) des flanschförmigen Fortsatzes (11a) der Dunkelraumabschirmung.

4. Zerstäubungskatode nach Anspruch 3, dadurch gekennzeichnet, daß das Maß "s" zwischen 2 und 5 mm, vorzugsweise zwischen 3 und 4 mm, beträgt.

5. Zerstäubungskatode nach Anspruch 1, dadurch gekennzeichnet, daß bei einer langgestreckten Zerstäubungsfläche (9) und einem Magnetsystem (5) zur Erzeugung einer rennbahnförmigen Erosionszone (15) mit zwei kreisringförmigen Endbereichen (15a) und zwei diese Endbereiche miteinander verbindenden linearen Mittenbereichen (15b) die umlaufenden Innenränder (12b,11b) der auf ein Zwischenpotial einstellbaren Elektrode (12) und des Fortsatzes (11a) der Dunkelraumabschirmung (11) im Bereich der kreisringförmigen Endbereiche (15a) durch je einen Halbkreis begrenzt sind, deren Halbmesser (R1, R2) dem äußeren Halbmesser (R3) der Endbereiche (15a) der Erosionszone (15) entsprechen.

6. Zerstäubungskatode nach Anspruch 5, dadurch gekennzeichnet, daß bei einem Target (8) mit einer rechteckigen Zerstäubungsfläche (9) der Fortsatz (11a) der Dunkelraumabschirmung (11) an seinem Außenrand (11c) von einem geometrisch ähnlichen Rechteck und an seinem Innenrand (11b) von zwei Halbkreisen (K2) und zwei diese Halbkreise miteinander verbindenden, zu dem Langseiten des Rechtecks parallel verlaufenden Geraden (G2) begrenzt ist (Fig. 1).

7. Zerstäubungskatode nach Anspruch 5, dadurch gekennzeichnet, daß bei einem Target (8) mit einer rechteckigen Zerstäubungsfläche (9) die auf ein Zwischenpotential einstellbare Elektrode (12) an ihrem Außenrand von einem geometrisch ähnlichen Rechteck und an ihrem Innenrand (12b) von zwei Halbkreisen (K1) und zwei diese Halbkreise miteinander verbindenden, zu den Langseiten des Rechtecks parallel verlaufenden Geraden (G1) begrenzt ist (Fig. 1).

8. Zerstäubungskatode nach Anspruch 1, dadurch gekennzeichnet, daß sich über der Mitte (M) der Zerstäubungsfläche (9) und über dem durch die Erosionszone (15) abgegrenzten Mittenbereich (17) eine diesen Bereich zumindest weitgehend abdeckende weitere Elektrode (13) befindet, die sich auf einem einstellbaren Potential befindet.

9. Zerstäubungskatode nach Anspruch 1, dadurch gekennzeichnet, daß der Katodengrundkörper (1) und die Elektrode (12) elektrisch und mechanisch miteinander verbunden und beide auf ein Zwischenpotential einstellbar sind, das zwischen dem Katodenpotential und dem Potential (Masse) der Dunkelraumabschirmung (11) liegt (Fig. 2).

10. Zerstäubungskatode nach den Ansprüchen 8 und 9, dadurch gekennzeichnet, daß der Katodengrundkörper (1) und die weitere, über der Mitte (M) der Zerstäubungsfläche (9) liegenden Elektrode (13) elektrisch und mechanisch miteinander verbunden und beide auf ein Zischenpotential einstellbar sind, das zwischen dem Katodenpotantial und dem Potential (Masse) der Dunkelraumabschirmung (11) liegt (Fig. 2).

## Claims

1. A sputtering cathode in accordance with the magnetron principle with a cathode basic body, a target having a sputtering surface and peripheral surfaces, and a magnet system which is arranged behind the target and possesses poles of opposing polarities, which are arranged one inside the other and are self-contained at the periphery, for the generation of magnetic field lines which emerge from the target and having passed along arcuate paths re-enter the target and thus form a self-enclosed magnetic tunnel above the sputtering surface, which tunnel encloses the plasma which occurs during operation and thus delimits on the one hand an erosion zone located in the sputtering surface and on the other hand non-erodible edge zones located outside of the erosion zone, where the cathode basic body and the peripheral surfaces of the target are surrounded by a dark space screen, characterised in that the edge zones (16) of the target (18) located outside of the erosion zone (15) are covered by a flange-like projection (11a) of the dark space screen (11), which projection (11a) extends in parallel to the sputtering surface (9) and possesses an inner edge (11b), and that between the dark space screen with the projection (16a) on the one hand and the delimited edge zones (16) of the sputtering surface (9), the peripheral surfaces (10) of the target (8) and the cathode basic body (1) on the other hand, is arranged at least one electrode (12) which is adjustable to an intermediate potential, is insulated from the target and from the dark space screen, possesses an inner edge (12b) and is of similar geometric configuration to the dark space screen (11).

2. A sputtering cathode as claimed in Claim 1, characterised in that the insulated electrode (12) is arranged so as to be freely adjustable to an intermediate potential.

3. A sputtering cathode as claimed in Claim 1, characterised in that the peripheral inner edge (12b) of the electrode (12), which is adjustable to an intermediate potential, is drawn further forwards towards the centre "M" of the sputtering surface (9) by a dimension "s" compared to the geometrically similar, peripheral inner edge (11b) of the flange-like projection (11a) of the dark space screen.

4. A sputtering cathode as claimed in Claim 3, characterised in that the dimension "s" amounts to between 2 and 5 mm, preferably between 3 and 4 mm.

5. A sputtering cathode as claimed in Claim 1, characterised in that with an elongate sputtering surface (9) and a magnet system (5) for the production of a track-shaped erosion zone (15) comprising two end zones (15a) in the form of circular rings and two linear central zones (15b) which interconnect said end zones, the peripheral inner edges (12b, 11b) of the electrode (12), which is adjustable to an intermediate potential, and of the projection (11a) of the dark space screen (11) are delimited in the region of the circular-ring-shaped end zones (15a) by a respective semicircle, the radii (R1, R2) of which correspond to the outer radius (R3) of the end zones (15a) of the erosion zone (15).

6. A sputtering cathode as claimed in Claim 5, characterised in that in the case of a target (8) having a rectangular sputtering surface (90, the projection (11a) of the dark space screen (11) is delimited at its outer edge (11c) by a rectangle of similar geometric configuration and at its inner edge (11b) by two semicircles (K2) and two straight lines (G2) which interconnect said semicircles and which extend in parallel to the longitudinal sides of the rectangle (Figure 1).

7. A sputtering cathode as claimed in Claim 5, characterised in that in the case of a target (8) having a rectangular sputtering surface (9), the electrode (12), which is adjustable to an intermediate potential, is delimited at its outer edge by a rectangle of similar geometric configuration and at its inner edge (12b) by two semicircles (K1) and two straight lines (G1) which interconnect said semicircles and extend in parallel to the longitudinal sides of the rectangle (Figure 1).

8. A sputtering cathode as claimed in Claim 1, characterised in that above the centre (M) of the sputtering surface (9) and above the central zone (17), which is delimited by the erosion zone (15), is arranged a further electrode (13) which at least substantially covers this zone and which carries an adjustable potential.

9. A sputtering cathode as claimed in Claim 1, characterised in that the cathode basic body (1) and the electrode (12) are electrically and mechanically connected to one another and both are adjustable to an intermediate potential which lies between the cathode potential and the potential (earth) of the dark space screen (11) (Figure 2).

10. A sputtering cathode as claimed in Claims 8 and 9, characterised in that the cathode basic body (1) and the further electrode (13), which is located above the centre (M) of the sputtering surface (9), are electrically and mechanically connected to one another and are both adjustable to an intermediate potential which lies between the cathode potential and the potential (earth) of the dark space screen (11) (Figure 2).

## Revendications

1. Cathode de pulvérisation selon le principe du magnétron avec un corps de base cathodique, avec une cible présentant une surface de pulvérisation et une surface périphérique et un système d'aimants disposé derrière la cible avec des pôles de polarité opposée emboîtés les uns dans les autres, se refermant sur eux-mêmes à la périphérie, pour la production de lignes de champ magnétique qui sortent de la cible et entrent à nouveau dis la cible après avoir parcouru un trajet en arc et forment ainsi sur la surface de pulvérisation un tunnel magnétique fermé sur lui-même, qui contient le plasma se produisant pendant la marche et limite ainsi, d'une part, une zone d'érosion située dans la surface de pulvérisation et, d'autre part, des zones marginales non érodables à l'extérieur de la zone d'érosion, de sorte que le corps de base cathodique et les faces périphériques de la cible sont entourés par un espace sombre de blindage, caractérisée en ce que les zones marginales (16) de la cible (8) situées à l'extérieur de la zone d'érosion (15) sont recouvertes par un prolongement en forme de bride (11a) de l'espace sombre de blindage (11) parallèle à la surface de pulvérisation (9), présentant un bord intérieur (11b) et en ce qu'il y a entre l'espace sombre de blindage avec son prolongement (16a), d'une part, et les zones marginales limitées (16) de la surface de pulvérisation (9), les faces périphériques (10) de la cible (8) et le corps de base cathodique (1), d'autre part, au moins une électrode (12) ayant un bord intérieur (12b), isolée de la cible et de l'espace sombre de blindage, mise à un potentiel intermédiaire, qui est semblable géométriquement à l'espace sombre de blindage (11).

2. Cathode de pulvérisation selon la revendication 1, caractérisée en ce que l'électrode isolée (12) est librement ajustée à un potentiel intermédiaire.

3. Cathode de pulvérisation selon la revendication 1, caractérisée en ce que le bord intérieur périphérique (12b) de l'électrode (12) réglable à un potentiel intermédiaire est décalé vers le milieu "M" de la surface de pulvérisation (9) d'une valeur "s" par rapport au bord intérieur périphérique (11b) géométriquement semblable du prolongement en forme de bride (11a) de l'espace sombre de blindage.

4. Cathode de pulvérisation selon la revendication 3, caractérisée en ce que la valeur "s" et comprise entre 2 et 5 mm, de préférence entre 3 et 4 mm.

5. Cathode de pulvérisation selon la revendication 1, caractérisée en ce que, dans le cas d'une surface de pulvérisation (9) très allongée et d'un système d'aimants (5) pour la production d'une zone d'érosion (15) en forme de vélodrome ayant deux zones d'extrémité en couronne (15a) et deux zones moyennes linéaires (15b) reliant entre elles ces zones d'extrémité, les bords intérieurs périphériques (12b, 11b) de l'électrode (12) réglable à un potentiel intermédiaire et du prolongement (11a) de l'espace sombre de blindage (11) sont limités chacun par un demicercle dans la zone des extrémités en couronne (15a), dont les rayons (R1, R2) correspondent au rayon extérieur (R3) des zones d'extrémité (15a) de la zone d'érosion (15).

6. Cathode de pulvérisation selon la revendication 5, caractérisée en ce que, dans le cas d'une cible (8) ayant une surface de pulvérisation (9) rectangulaire, le prolongement (11a) de l'espace sombre de blindage (11) est limité à son bord extérieur (11c) par un rectangle géométriquement semblable et à son bord intérieur (11b) par deux demi-cercles (K2) et deux droites (G2) reliant ceux-ci entre eux et parallèles au grand côté du rectangle (figure 1).

7. Cathode de pulvérisation selon la revendication 5, caractérisée en ce que, dans le cas d'une cible (8) ayant une surface de pulvérisation (9) rectangulaire, l'électrode (12) réglable à un patentiel intermédiaire est limitée à son bord extérieur par un rectangle géométriquement semblable et à son bord intérieur (12b) par deux demi-cercles (K1) et deux droites (G1) reliant ceux-ci entre eux, parallèles au grand côté du rectangle (figure 1).

8. Cathode de pulvérisation selon la revendication 1, caractérisée en ce qu'il y a au-dessus du milieu (M) de la surface de pulvérisation (9) et au-dessus de la zone moyenne limitée par la zone d'érosion (15) une autre électrode (13) recouvrant au moins largement cette zone, qui se trouve à un potentiel réglable.

9. Cathode de pulvérisation selon la revendication 1, caractérisée en ce que le corps de base cathodique (1) et l'électrode (12) sont reliés entre eux électriquement et mécaniquement et les deux sont réglables à un potentiel intermédiaire qui est compris entre le potentiel de la cathode et le potentiel (masse) de l'espace sombre de blindage (11)(figure 2).

10. Cathode de pulvérisation selon les revendications 8 et 9, caractérisée en ce que le corps cathodique de base (1) et l'autre électrode (13) située au-dessus du milieu (M) de la surface de pulvérisation (9) sont reliés entre eux électriquement et mécaniquement et les deux sont réglables à un potentiel intermédiaire qui est compris entre le potentiel de la cathode et le potentiel (masse) de l'espace sombre de blindage (11)(figure 2).
